**Europäisches Patentamt**

**European Patent Office**

**Office européen des brevets**

(11) Veröffentlichungsnummer: **0 089 511**
**B1**

(12) # EUROPÄISCHE PATENTSCHRIFT

(45) Veröffentlichungstag der Patentschrift:
11.06.86

(51) Int. Cl.⁴: **G 01 D 3/08, H 03 M 13/00**

(21) Anmeldenummer: **83101817.1**

(22) Anmeldetag: **24.02.83**

(54) **Verfahren zur Auswertung der Ausgangsimpulsfolgen eines inkrementalen Lagegebers und Schaltungsanordnung zur Durchführung des Verfahrens.**

(30) Priorität: **09.03.82 DE 3208446**

(43) Veröffentlichungstag der Anmeldung:
**28.09.83 Patentblatt 83/39**

(45) Bekanntmachung des Hinweises auf die Patenterteilung:
**11.06.86 Patentblatt 86/24**

(84) Benannte Vertragsstaaten:
**CH DE FR GB IT LI SE**

(56) Entgegenhaltungen:
**DE - A - 1 955 917**
**FR - A - 2 406 804**
**GB - A - 1 074 500**
**US - A - 3 670 324**

(73) Patentinhaber: **Siemens Aktiengesellschaft, Berlin und München Wittelsbacherplatz 2, D-8000 München 2 (DE)**

(72) Erfinder: **Röhrle, Josef, Dipl.-Ing., Am Kahlberg 12, D-8521 Hessdorf (DE)**

## Beschreibung

Die Erfindung betrifft ein Verfahren zur Auswertung der Ausgangsimpulsfolgen eines inkrementalen Lagegebers mit zwei Signalkanälen, an denen zwei in Abhängigkeit von der Bewegungsrichtung des Lagegebers phasenverschobene Ausgangsimpulsfolgen anstehen sowie mit einer dem Lagegeber nachgeschalteten Zählschaltung, die die positiven und die negativen Flanken der Ausgangsimpulse zählt, und zwar in Abhängigkeit vom Zustand des jeweils anderen Signalkanals in Vorwärts- oder in Rückwärtsrichtung unter Verwendung einer der Zählschaltung vorgeschalteten Störausblendeschaltung sowie eine Schaltungsanordnung zur Durchführung des Verfahrens.

Inkrementale Lagegeber der genannten Art sind im Handel erhältlich. Diese Lagegeber enthalten im allgemeinen eine mit einem bewegten Teil verbundene Geberscheibe mit Markierungen in festgelegten Abständen. Diese Geberscheibe wird optisch oder induktiv mit einem Fühler abgetastet, so daß eine Ausgangsimpulsfolge gebildet wird, deren Frequenz der Geschwindigkeit des bewagten Teils proportional ist. Durch Zählen der abgegebenen Ausgangsimpulse erhält man eine Lageinformation für das bewegte Teil. Auf diese Weise können mit einer rotierenden Geberscheibe z.B. auch Winkelschrittgeber aufgebaut sein.

Um auch eine Information über die Bewegungsrichtung zu bekommen, wird mit einem zweiten, versetzt angeordneten Fühler eine zweite Ausgangsimpulsfolge erzeugt, die gegenüber der ersten Ausgangsimpulsfolge im Idealfall um 90° phasenverschoben ist. Dabei beträgt die Phasenverschiebung beispielsweise + 90°, wenn eine Bewegung in einer vorgegebenen positiven Richtung erfolgt, und - 90°, wenn eine Bewegung in gegengesetzter Richtung erfolgt. Zur Berücksichtigung der Bewegungsrichtung weist eine dem Lagegeber nachgeschaltete Zählschaltung Steuereingänge für Zählen in Vorwärts- und in Rückwärtsrichtung auf. Die ansteigenden Flanken der Ausgangsimpulse des einen Signalkanals werden beispielsweise in Vorwärtsrichtung gezählt, wenn am anderen Signalkanal gerade "1" ansteht und in Rückwärtsrichtung, wenn im anderen Signalkanal "0" ansteht. Umgekehrt werden die fallenden Flanken in Vorwärtsrichtung gezählt, wenn am anderen Signalkanal gerade "0" ensteht und in Rückwärtsrichtung, wenn am anderen Signalkanal gerade "1" ansteht.

Bei diesem Verfahren führen jedoch Störsignale, sofern sie während eines Signalwechsels im zweiten Signalkanal auftreten, zu bleibenden Fehlern im Lage-Meßsignal.

Ein Verfahren und eine Einrichtung der eingangs genannten Art sind aus der DE-A- 19 55 917 bekannt. Dabei werden beide Signalkanäle gleichzeitig beeinflussende Störsignale zunächst zwar gezählt, jedoch erfolgt daraufhin eine Korrektur des Zählergebnisses.

Aufgabe der Erfindung ist es, ein Verfahren und eine Schaltungsanordnung der eingangs genannten Art so auszugestalten, daß derartige Störsignale, sofern sie während eines Signalwechsels im zweiten Signalkanal auftreten, nicht zu Fehlern im Lage-Meßsignal führen.

Diese Aufgabe wird erfindungsgemäß dadurch gelöst, daß die Störausblendeschaltung bei jedem Signalwechsel in einem Signalkanal einen Signalwechsel im anderen Signalkanal für eine Zeit blockiert, die größer ist als eine maximal zu erwartende Störimpulsdauer. Damit wird erreicht, daß die Zählschaltung die ansteigende Flanke des Störimpulses in einer Richtung und die abfallende Flanke des Störimplses in der anderen Richtung zählt, so daß der Störimpuls letztlich keine Auswirkungen auf das Lage-Meßsignal hat.

Vorteilhafterweise wird jeder Ausgangsimpuls, dessen Impulsdauer kürzer ist als eine von der Zählschaltung sicher zu verarbeitende Mindest-Impulsdauer, auf diese Mindest-Impulsdauer verlängert. Kurze Impuls spitzen können nämlich zu einer völlig undefinierten Zählung führen. Durch die Verlängerung auf eine Mindest-Impulsdauer wird der Störimpuls voll erfaßt. Da jedoch, wie bereits ausgeführt, eine Flanke in positiver und eine Flanke in negativer Richtung gezählt wird, hat er keinen Einfluß auf das Lage-Meßsignal.

Bei einer Schaltungsanordnung zur Durchführung des Verfahrens enthält die Störausblendeschaltung für jeden Signalkanal einen ersten und einen zweiten taktgesteuerten Speicher, wobei in jedem Signalkanal die Ausgangsimpulsfolge über jeweils eine Verriegelungsstufe einem ersten Eingang des jeweils ersten Speichers zugeführt ist, wobei jeweils der Ausgang des ersten Speichers mit einem Eingang des zweiten Speichers verbunden ist, wobei jeweils der Ausgang und der Eingang jedes zweiten Speichers mit einer Antivalenzstufe verbunden ist, die die Verriegelungsstufe des jeweils anderen Signalkanals so steuert, daß diese Verriegelungsstufe sperrt, solange die an den Eingängen der Antivalenzstufe anstehenden Signale nicbt übereinstimmen und wobei der Ausgang jedes zweiten Speichers mit der nachgeschalteten Zählschaltung verbunden ist. Mit dieser Schaltung wird erreicht, daß ein Signalwechsel in einem Signalkanal solange verzögert wird, bis die Verarbeitung eines vorangegangenen Signalwechsels abgeschlossen ist. Ferner wird jeder Ausgangsimpuls auf eine Mindest-Länge gebracht.

Als Speicher werden am einfachsten taktflankengesteuerte JK-Flip-Flops verwendet, wobei jeweils einem Eingang des ersten JK-Flip-Flops die Ausgangsimpulsfolge und dem anderen Eingang die invertierte Ausgangsimpulsfolge zugeführt wird.

Zweckmäßigerweise werden die Speicher der beiden Signalkanäle mit phasenverschobenen Takten angesteuert. Damit wird verhindert, daß

sich gleichzeitige Impulsflanken in beiden Signalkanälen gegenseitig sperren.

Eine versetzte Ansteuerung beider Speicher wird auch erreicht, wenn die JK-Flip-Flops eines Signalkanals mit den positiven Flanken und die JK-Flip-Flops des anderen Signalkanals mit negativen Flanken derselben Taktimpulsfolge angesteuert werden.

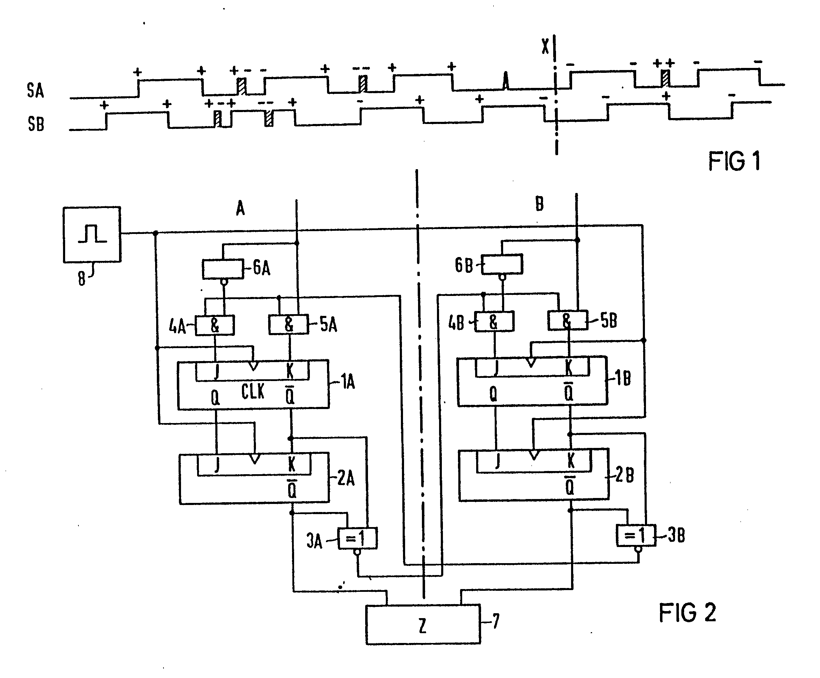

Ein Ausführungsbeispiel der Erfindung wird nachfolgend anhand der Figuren 1 bis 3 näher erläutert.

Figur 1 zeigt ein Impulsdiagramm zur Erläuterung der Problemstellung. Dabei sind mit SA bzw. SB die Ausgangsimpulsfolgen in den beiden Signalkanälen A bzw. B bezeichnet. In beiden Ausgangsimpulsfolgen SA bzw. SB sind Störimpulse enthalten, die durch Schraffur gekennzeichnet sind.

Wie Figur 1 deutlich zeigt, sind die Ausgangsimpulse der Impulsfolge SB gegenüber den Ausgangsimpulsen der Impulsfolge SA um 90° verschoben. Dabei beträgt die Phasenverschiebung +90°, bis zu einem in Figur 1 eingetragenen Zeitpunkt x die Bewegungsrichtung des Lagegebers ungekehrt wird. Ab dem Zeitpunkt X beträgt die Phasenverschiebung der Ausgangsimpulse SB - 90° gegenüber SA.

Mit der bereits eingangs beschriebenen Auswerteschaltung werden die Ausgangsimpulsfolgen SA und SB durch eine Zählschaltung wie folgt ausgewertet: Die ansteigenden Flanken der Ausgangsimpulse SA werden positiv gezählt, wenn im Signalkanal B gerade ein "1 " -Signal ansteht und sie werden negativ gezählt, wenn im Signalkanal B ein "0"-Signal ansteht. Umgekehrt werden die fallenden Flanken der Ausgangsimpulse A positiv gezählt, wenn im Signalkanal B ein "0"-Signal ansteht umd sie werden negativ gezählt, wenn im Signalkanal B ein "1"-Signal ansteht. Auf analoge Weise wird die Zählweise für die Flanken der Impulsreihe SB durch den Signalzustand im Signalkanal A bestimmt. Die Zählweise für die einzelnen Flanken ist in Figur 1 mit "+" bzw. "−" gekennzeichnet

Wenn man zunächst nur die ungestörten Ausgangsimpulse betrachtet, so sieht man, daß alle Impulsflanken bis zum Zeitpunkt x positiv und nach der Richtungsumkehr zum Zeitpunkt x negativ gezählt werden. Am Ausgang einer nach dem beschriebenen, bekannten Verfahren arbeitenden Zählschaltung steht also eine Zahl an, die ein Lage-Meßsignal darstellt.

Betrachtet man nun die Störimpulse, so erkennt man folgenden Sachverhalt: Beim ersten Störimpuls der Ausgangsimpulsfolge SA wird die ansteigende Flanke positiv und die abfallende Flanke negativ gezählt, da im Signalkanal B während des ganzen Störimpulses ein "1"- Signal ansteht. Der mit der ansteigenden Planke des Störimpulses verursachte Zählfehler wird also mit der abfallenden Flanke wieder kompensiert, so daß das Lage-Meßsignal richtig bleibt. Dasselbe gilt für den ersten Störimpuls in der Ausgangsimpulsfolge SB. Da während der gesamten Dauer dieses Impulses das Signal im Signalkanal SA "0" ist, folgt ebenfalls auf einen positiven Zählimpuls ein negativer Zählimpuls, die sich gegenseitig kompensieren. Anders ist die Lage beim zweiten Störimpuls der Ausgangsimpulsfolge SB. Dessen fallende Flanke wird negativ gezählt, da das Signal im Signalkanal A in diesem Fall auf "0" ist. Aber auch die ansteigende Flanke dieses Störimpulses wird negativ gezählt, da das Signal im Signalkanal A inzwischen auf "1" gewechselt hat. Dasselbe gilt such für den zweiten Störimpuls in der Ausgangsimpulsfolge SA. Auch hier werden beide Flanken negativ gezählt, da zwischen der ansteigendem und abfallenden Flanke des Störimpulses ein Signalwechsel im Signalkanal 8 stattfindet.

Auch der dritte, sehr kurze Störimpuls der Ausgangsimpulsfolge SA kann zu einem Fehler im Enge-Meßsigual führen, da derartige kurze Störimpulse zu einer Fehlfunktion des Zählers führen können. Beispielsweise ist es möglich, daß nur die positive Flanke dieses Störimpulses erfaßt wird und somit ebenfalls einen bleibenden Fehler im Lage-Meßsignal hervorruft.

Aus den bisherigen Betrachtungen erkennt man also, daß Störimpulse nicht zu einem Fehler im Lage-Meßsignal führen, wenn zwischen den beiden Flanken des Störimpulses kein Sigualwechsel im jeweils anderen Signalkanal stattfindet. Zu einem Fehler im Lage-Meßsignal führen dagegen Störimpulse, in deren Dauer ein Sigualwechsel im jeweils anderen Signalkanal fällt. Ebenso können sehr kurze Störimpulse zu einem Meßfehler führen, auch wenn kein Signalwechsel im anderem Signalkanal stattfindet.

Gemäß der vorliegenden Erfindung wird diese Störbeeinflussung nun dadurch beseitigt, daß eine der Zählschaltung vorgeschaltete Störausblendeschaltung bei jedem Signalwechsel in einem Signalkanal einen Sigualwechsel im anderen Signalkanal für eine Zeit blockiert, die größer ist als eine maximal zu erwartende Störimpulsdauer. Wenn also nach Beginn eines Störimpulses in einem Signalkanal ein Signalwechsel im anderen Signalkanal folgt, so wird der letztere für eine Zeitdauer blockiert, die länger ist als die Dauer des Störimpulses. Nach der Störausblendeschaltung kann also während der Dauer eines Störimpulses kein Sigualwechsel im anderen Signalkanal stattfinden. Aufgrund der vorstehenden Aus führung können daher Störsignale nicht mehr zu einer Verfälschung des Lage-Meßsignals führen.

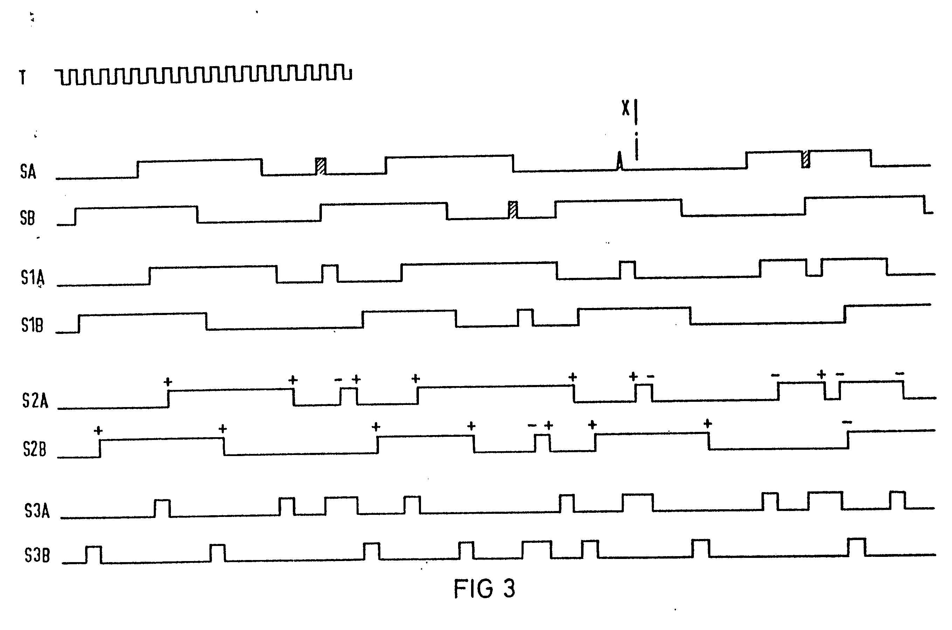

Ein Ausführungsbeispiel für eine Schaltungsanordnung zur Durchführung des Verfahrens wird nachfolgend anhand der Figur 2 und des zugehörigen Impulsdiagramms nach Figur 3 beschrieben.

In Figur 2 ist eine Störausblendeschaltung mit zwei identisch aufgebauten Signalkanälen A, B dargestellt. Jeder Signalkanal erhält eine Ausgangsimpulsfolge eines nicht dargestellten inkrementalen Lagegebers als Eingangssignal. Diese Ausgangsimpulsfolge wird jeweils einem Eingang eines UND-Gatters 5A bzw. 5B sowie über einen Inverter 6A bzw. 6B einem Eingang eines UND-Gatters 4A bzw. 4B zugeführt. Der Ausgang des UND-Gatters 4A bzw. 4B ist mit dem J-Eingang eines JK-Flip-Flops 1A bzw. 1B verbunden und der Ausgang des·UND-Gatters 5A bzw. 5B mit dem K-Eingang desselben Flip-Flops. Die Ausgänge Q und Q der JK-Flip-Flops 1A und 1B sind mit den J- bzw. K-Eingängen eines zweiten JK-Flip-Flops 2A bzw. 2B verbunden. Der Ausgang Q des zweiten JK-Flip-Flops 2A bzw. 2B ist mit einem ersten und der K-Eingang desselben Flip-Flops ist mit einem zweiten Eingang eines Exlusiv-ODER-Gatters 3A bzw. 3B verbunden. Jedes Exklusiv-ODER-Gatters 3A bzw. 3B weist einen invertierenden Ausgang auf und stellt daher eine Antivalenzstufe dar. Der invertierende Ausgang jedes Exklusiv-ODER-Gatters 3A bzw. 3B ist mit dem zweiten Eingang des UND-Gatters 4B und 5B bzw. 4A und 5A des jeweils anderen Signalkanals verbunden. Die Ausgänge Q der zweiten JK-Flip-Flops 2A und 2B beider Signalkanäle A, B sind mit einer Zählschaltung 7 verbunden, die in bekannter Weise aufgebaut ist.

Die Takteingänge aller Flip-Flops 1A, 2A und 1B, 2B werden von einem Taktgeber 8 angesteuert, wobei jedoch die JK-Flip-Flops IA und 2A des Signalkanals A mit der positiven Flanke und die JK-Flip-Flops 1B und 2B des Signalkanals B mit der negativen Flanke des Taktes angesteuert. werden.

In Figur 3 sind nochmals die beiden Ausgangsimpulsfolgen SA und SB der beiden Signalkanäle A und B dargestellt. Die se Ausgangsimpulsfolgen enthalten schraffiert dargestellte Störimpulse, die bei herkömmlichen Anordnungen wie erläutert zu Lage-Meßfehleru führen. Mit T ist das Taktsignal des Taktgebers 8 bezeichnet und mit SIA und S1B bzw. S2A und S2B die Ausgangssignale der Ausgänge Q der JK-Flip-Flops 1A und 1B bzw. 2A und 2B. Die Ausgangssignale der Exklusiv-ODER-Gatter 3A bzw. 3B sind schließlich mit S3A bzw. S3B bezeichnet.

Die Wirkungsweise der Schaltung wird nachfolgend anhand einiger Taktperioden erläutert. Beim Diagramm nach Figur 3 wechselt zuerst das Ausgangssignal im Signalkanal B auf "1". Dieser Wechsel wird mit der nächstfolgenden negativen Flanke in den Speicher 1B überuommen. Da der Speicher 2B zunächst noch auf Null bleibt, entsteht damit an Ausgang des Exklusiv-ODER-Gatters 3B ein "1"-Signal. Mit der nächsten negativen Flanke wird das "1"-Signal des Speichers 1 B auch in den Speicher 2B übernommen, so daß das "1"-Signal am Ausgang des Exklusiv-ODER-Gatters 3B wieder verschwindet. Solange am Ausgang des Exklusiv-ODER-Gatters 3B ein "1"-Signal ansteht, werden die Eingänge des Speichers 1A blockiert, was jedoch keine Auswirkung hat, da in dieser Zeit ohnehin kein Wechsel des Signals im Signalkanal A auftritt.

Ebenso wird der daraufolgende Wechsel des Signals im Signalkanal A verarbeitet, wobei lediglich die Übernahme in den ersten Speicher 1A mit der ersten auf den Signalwechsel folgenden positiven Flanke des Taktsignals und die Signalübernahme in den zweiten Speicher S2A mit der zweiten positiven Flanke erfolgt. Auch dabei werden für eine auf den Signalwechsel im Signalkanal A folgende Periode des Taktsignals die Eingänge des Speichers 1B gesperrt.

Der Signalübergang von 1 auf 0 wird analog verarbeitet. Man erkennt also, daß ungestörte Eingangsimpulse mit einer Verzögerung von maximal zwei Taktperioden an den Ausgang des zweiten Speichers 2A bzw. 2B weitergegeben werden. Ferner ist festzustellen, daß nach jedem Signalwechsel in einem Signalkanal der erste Speicher 1A bzw. 1B im anderen Signalkanal für eine auf den Signalwechsel folgende Taktperiode gesperrt wird, was sich jedoch im Normalfall nicht auswirkt, da in der Sperrzeit ohnehin kein Signalwechsel stattfindet.

Im folgenden wird nun die Verarbeitung des ersten Störimpulses der Ausgangsimpulsfolge SA erläutert. Dieser Störimpuls wird mit der nächstfolgenden positiven Flanke des Taktsignals in den Speicher S1A übernommen. Mit der darauffolgenden positiven Flanke des Taktsignals, bei der der Störimpuls wieder abgeklungen ist, wird auch der Speicher S1A wieder auf "0" gesetzt, gleichzeitig wird jedoch der Störimpuls in den Speicher S2A übernommen. Nach einer Taktperiode wird auch der Speicher S2A wieder auf "0" gesetzt. Ein Vergleich der Ausgangssignale des Speichers 1A und 2A zeigt, daß diese für zwei Taktperioden nicht übereinstimmen, so daß über die Antivalenzstufe 3A die Eingänge des Speichers 1B gesperrt werden. In dieser Zeit wechselt das Ausgangssignal im Signalkanal B von "0" nach"7" Dieser Wechsel kann jedoch erst mit der ersten auf die Sperrzeit des Speichers 18 folgenden negativen Flanke des Taktsignals in den Speicher 1B und mit der darauffolgenden negativen Flanke des Taktsignals in den Speicher 2B übernommen werden. Die Übernahme des Impulses im Signalkanal B in den Speicher 2B ist also gegenüber der Übernahme des Impulses im Signalkanal A in den Speicher 2A um insgesamt zwei Taktperioden verzögert. Dabei ist wesentlich, daß die Übernahme in den Speicher 2B erst erfolgt, sobald die Verarbeitung des Störsignals im Speicher 2A abgeschlossen ist. Es findet also kein Signalwechsel im Speicher 2B statt, solange am Ausgang des Speichers 2A noch der Störimpuls ansteht. Wie bereits eingangs erläutert, wird damit durch den Störimpuls ein positiver und ein negativer Zählimpuls ausgelöst, die sich gegenseitig aufheben. Man erkennt also, daß die nach jedem Signalwechsel in einem Signalkanal erfolgende Blockierung des anderen Signalkanals, die im Normalfall wirkungslos bleibt, beim dargestellten Störsignal zu einer Verschiebung des Flankenwechsels im anderen Signalkanal führt. Die Blockierung des anderen Signalkanals dauert für jeden Signalwechsel eine Taktperiode, bei den durch das Störsignal verursachten unmittelbar aufeinanderfolgenden beiden Signalwechseln also zwei Taktperioden.

Dasselbe gilt auch für das in Figur 3 dargestellte Störsignal im Signalkanal B, das mit einer abfallenden Flanke des Signals SA zusammenfällt. Auch hierbei werden für zwei auf das Störsignal folgende Taktperioden die Eingänge des Speichers 1A blockiert. Der Signalwechsel im Signalkanal A kann daher erst nach dieser Blockierzeit in den Speicher 1A und nach einer weiteren Taktperiode in den Speicher 2A überuommen werden. Am Ausgang des Speichers 2A findet daher der Signalwechsel erst statt, wenn am Ausgang des Speichers 2B das Störsignal bereits verschwunden ist. In diesem Fall wurde also die abfallende Flanke eines Signals verzögert.

Das zweite Störsignal in der Ausgangsimpulsfolge SA stellt einen hnrzen Störimpuls dar, der wie dargelegt auch dann zu Fehlzählungen zählen könnte, wenn er nicht mit einer Flanke des Signals im Signalkanal B zusammenfällt. Dieser kurze Störimpuls wird im Speicher 1A auf eine Taktperiode verlängert und mit Verzögerung von einer Taktperiode in den Speicher 2A übernommen. Die Eingänge des Speichers 1A werden dabei für zwei Taktperioden gesperrt, was sich jedoch nicht auswirkt, da im Signalkanal A in dieser Zeit kein Signalwechsel stattfindet. Aus dem kurzen Störimpuls wird also am Ausgang des Speichers 2A ein Impuls, der von der Zählschaltung 7 normal ausgewertet werden kann. Da eine Flanke mit "+" und die zweite Flanke "−" gezählt wird, wirkt sich der Störimpuls nicht auf das Lage-Meßsignal aus.

Mit dem dritten Störsignal der Ausgangsimpulsfolge SA wird schließlich das "1"-Signal eines Ausgangsimpulses auf "0" verfälscht, wobei gleichzeitig ein Signalwechsel von "0" nach "1" im Signalkanal B stattfindet. Auch dieser Störimpuls wird mit einer Verzögerung von maximal zwei Taktperioden auf den Ausgang des Speichers 2A übertragen und führt für zwei Taktperioden zu einer Sperrung der Eingänge des Speichers 1B. Damit wird wieder der Signalwechsel im Kanel B soweit verzögert, daß er am Ausgang des Speichers 2B erst auftritt, wenn das Störsignal am Ausgang des Speichers 2A bereits verschwunden ist.

Zusammenfassend ist also festzustellen, daß die beschriebene Störausblendeschaltung verhindert, daß während der Verarbeitung eines Störimpulses in einem Signalkanal ein Signalwechsel im anderen Signalkanal stattfindet. Damit werden jedoch, wie erläutert, die Störimpulse unschädlich. Das gilt allerdings nur solange die Störimpulse kürzer sind als eine Taktperiode. Die Taktperiode muß daher etwas länger gemacht werden als die maximal zu erwartende Störimpulsbreite. Andererseits muß der Taktflankenabstand kleiner sein als der minimale Flankenabstand der Ausgangsimpulse in den Signalkanälen A, B, da sonst die Phasenverschiebung der beiden Ausgangsimpulse verloren geht und damit die Drehrichtung nicht mehr erkannt wird. Die Taktfrequenz ist also unter Berücksichtigung dieser beiden Forderungen zu wählen.

**Patentansprüche**

1. Verfahren zur Auswertung der Ausgangsimpulsfolgen (SA, SB) eines inkrementalen Lagegebers mit zwei Signalkanälen (A, B), an denen zwei in Abhängigkeit von der Bewegungsrichtung des Lagegebers Phasenverschobene Ausgangsimpulsfolgen (SA, SB) anstehen, sowie mit einer dem Lagegeber nachgeschalteten Zählschaltung (7), die die positiven und negativen Flanken der Ausgangsimpulse zählt, und zwar in Abhängingkeit vom Zustand des jeweils anderen Signalkanals (A, B) in Vorwärts- oder in Rückwärtsrichtung, unter Verwendung einer der Zählschaltung (7) vorgeschalteten Störausblendschaltung, dadurch gekennzeichnet, daß die Störausblendeschaltung bei jedem Signalwechsel in einem Signalkanal (A, B) einen Signalwechsel im anderen Signalkanal (A, B) für eine Zeit blockiert, die größer ist als maximal zu erwartende Störimpulsdauer. 2. Verfahren nach Anspruch 1, dadurch gekennzeichnet, daß jeder Ausgangsimpuls, dessen Impulsdauer kürzer ist als eine von der Zählschaltung sicher zu verarbeitende Mindest-Impulsdauer, auf diese Mindest-Impulsdauer verlängert wird.

3. Schaltungsanordnung für einer inkrementalen Lagegeber mit zwei Signalkanälen (A, B), einer dem Lagegeber nachgeschalteten Zählschaltung (7) und dieser vorgeschalteten Störausblendeschaltung (5A, 5B; 6A, 6B...) zur Durchführung eines Verfahrens nach Anspruch 1 oder 2, dadurch gekennzeichnet, daß die Störausblendeschaltung für jeden Signalkanal (A, B) einen ersten und einen zweiten taktgesteuerten Speicher (1 A; 2A; 1 B; 2B) enthält, daß in jeden Signalkanal (A, B) die Ausgangsimpulsfolge über jeweils eine Verriegelungsstufe (4A; 5A; 4B; 5B) einem ersten Eingang des jeweils ersten Speichers (1 A, 1 B) zugeführt ist, daß jeweils der Ausgang des ersten Speichers (1 A, 1 B) mit einem Eingang des zweiten Speichers (2A, 2B) verbunden ist, daß jeweils der Ausgang und der Eingang jedes zweiten Speichers (2A, 2B) mit einer Antivalenzstufe (3A, 3B) verbunden ist, die die Verriegelungsstufe (4A; 5A; 4B; 5B) des jeweils anderem Signalkanals (A, B) so steuert, daß diese Verriegelungsstufe (4A; 5A; 4B; 5B) sperrt, solange die an dem Eimgämgen der Antivalenzstufe (3A, 3B) anstehendem Signale nicht übereinstimmen und daß der Ausgang jedes zweiten Speichers (2A, 2B) mit der nachgeschalteten Zählschaltung (7) verbunden ist.

4. Schaltungsanordmung nach Anspruch 3, dadurch gekennzeichnet, daß die Speicher (1A; 1B; 2B) taktflankengesteuerte JK-Flip-Flops sind, wobei jeweils einem Eingang des ersten JK-Flip-Flops (1A, 1B) die Ausgangsimpulsfolge und dem anderen Eingang die invertierte Ausgangsimpulsfolge zugeführt wird.

5. Schaltungsanordnung nach Anspruch 3 oder 4, dadurch gekennzeichnet, daß die Speicher (1A; 2A; 1B; 2B) der beidem Signalkanäle mit phasenverschobenen Takten angesteuert werden.

6. Schaltungsanordnung nach Anspruch 4, dadurch gekennzeichnet, daß die JK-Flip-Flops (1A, 2A) eines Signalkanals (A) mit den positiven Flanken und die JK-Flip-Flops (1B, 2B) des anderen Signalkanals (B) mit negativen Flanken derselben Taktimpulsfolge angesteuert werden.

## Claims

1. A method of analysing output signal sequences (SA, SB) of an incremental position pick-up having two signal channels (A, B) in which occur two output pulse sequences (SA, SB) which are displaced in phase in dependence upon the direction of movement of the position pick-up, and with a counting circuit (7) which is connected to the output end of the position pick-up and which counts the positive and negative flanks of the output pulaes, and that in dependence upon the state of the particular other signal channel (A, B) in the forwards or the backwards direction, using an interference gatingout circuit which is connected to the input end of the counting circuit (7), characterised in that whenever a signal change occurs in a signal channel (A, B), the interference gating-out circuit blocks a signal change in the other signal channel (A, B) for a length of time which is greater than the maximum likely duration of an interference pulse.

2. A method as claimed in claim 1, characterised in that each output pulse whose duration is shorter than a minimum pulse duration which can be reliably processed by the counting circuit is extended to this minimum pulse duration.

3. A circuit arrangement for an incremental position pick-up having two signal channels (A, B), a counting circuit (7) connected to the output end of the position pick-up, and an interference gating-out circuit (5A, 5B; 6A, 6B...) which is connected to the input end of said counting circuit, for the implementation of a method as claimed in claim 1 or 2, characterised in that for each signal channel (A, B) the interference gating-out circuit includes a first and a second clock-controlled store (1A; 2A; 1B; 2B), that in each signal channel (A, B) the output pulse sequence leads via a blocking stage (4A; 5A; 4B; 5B) to a first input of the first store (1A, 1B), that the output of the first store (1A, 1B) is in each case connected to an input of the second store (2A, 2B), that the output and the input of each second store (2A, 2B) are each connected to an exclusive-OR stage (3A, 3B) which controls the blocking stage (4A; 5A; 4B; 5B) of the other signal channel (A, B) in such manner that this blocking stage (4A; 5A; 4B; 5B) blocks for such time as the signals occurring at the inputs of the exclusive-OR stage (3A, 3B) are not identical, and that the output of each second store (2A, 2B) is connected to the following counting circuit (7).

4. A circuit arrangement as claimed in claim 3, characterised in that the stores (1A; 2A, 1B, 2B) are clockflank-controlled JK-flip-flips, where one input of the first JK-flip-flop (1A, 1B) is supplied with the output pulse sequence and the other input is supplied with the inverted output pulse sequence.

5. A circuit arrangement as claimed in claim 3 or 4, characterised in that the stores (1A; 2A; 1B; 2B) of the two signal channels are driven by phase-displaced clock pulses.

6. A circuit arrangement as claimed in claim 4, characterised in that the JK-flip-flops (1A, 2A) of a signal channel (A) are controlled by the positive flanks, and the JK-flip-flops (1B, 2B) of the other signal channel (B) are controlled by the negative flanks of the same clock pulse sequence.

## Revendications

1. Procédé pour exploiter des trains d'impulsions de sortie (SA, SB) d'un capteur incrémental de position, comportant deux canaux (A, B) de transmission des signaux, dans lesquels sont présentes deux trains d'impulsions de sortie (SA, SB) dephases en fonction de la direction de déplacement du capteur de position, ainsi qu'un circuit de comptage (7) branché en aval du capteur de position et qui compte les flancs positifs et négatifs des impulsions de sortie, et ce en fonction de l'état de l'autre canal respectif (A, B) de transmission des signaux, dans le sens progressif ou dans le sens régressif, moyennant l'utilisation d'un circuit de suppression de parasites branché en amont du circuit de comptage (7), caractérisé par le fait que lors de chaque changement de signal dans un canal (A, B) de transmission des signaux, le circuit de suppression des parasites bloque un changement de signal dans l'autre canal (A, B) de transmission de signaux pendant un intervalle de temps qui est supérieur à une durée maximum des impulsions parasite à laquelle on peut s'attendre.

2. Procédé suivant la revendication 1, caractérisé par le fait que chaque impulsion de sortie, dont la durée est plus courte qu'une durée minimum d'impulsion devant être traitée de façon sûre par le circuit de comptage, est prolongée jusqu'à posséder cette durée minimale d'impulsion.

3. Montage pour un capteur incrémental de position comportant deux canaux (A, B) de transmission des signaux, un circuit de comptage (7) branche en aval du capteur de position et un circuit (5A, 5B; 6A, 6B...) de suppression de parasites branché en aval de ce circuit pour la mise en oeuvre d'un procédé selon la revendication 1 ou 2, caractérisé par le fait que le circuit de suppression de parasites contient, pour chaque canal (A, B) de transmission des signaux, une première et une seconde mémoires (1A; 2A; 1B; 2B) commandées de façon cadencée, que dans chaque canal (A, B) de transmission de signaux, le train d'impulsions de sortie est envoyée par l'intermédiaire respectivement d'un etage de verrouillage (4A; 5A; 4B; 5B) à une première entrée de la première mémoire respective (1A, 1B), que respectivement la sortie de la première mémoire (1A, 1B) est reliée à une entrée de la seconde mémoire (2A, 2B), que respectivement la sortie et l'entrée de chaque seconde mémoire (2A, 2B) sont reliées à un étage d'anticoïncidence (3A, 3B) qui commande l'étage de verrouillage (4A; 5A; 4B; 5B) de l'autre canal respectif (A, B) de transmission des signaux de telle sorte que cet étage de verrouillage (4A; 5A; 4B; 5B) se bloque tant que les signaux présents aux entrées de l'étage d'anticoïncidence (3A, 3B) ne coincident pas et, que la sortie de chaque seconde mémoire (2A, 2B) est reliée au circuit de comptage (7) branché en aval.

4. Montage suivant la revendication 3, caractérisé par le fait que les mémoires (1A; 2A; 1B; 2B) sont des bascules bistables de type JK commandées de façon cadencée par les flancs des impulsions, la suite d'impulsions de sortie étant envoyé respectivement à une entrée d'une première bascule de type JK (1A, 1B) et le train d'impulsions de sortie inversée étant envoyée à l'autre entrée.

5. Montage suivant la revendication 3 ou 4, caractérisé par le fait que les mémoires (1A; 2A; 1B; 2B) des deux canaux de transmission des signaux sont commandées avec des impulsions de signaux de cadence déphasées.

6. Montage suivant la revendication 4, caractérisé par le fait que les bascules bistables de type JK (1A, 2A) d'un canal (A) de transmission des signaux sont commandées par les flancs positifs et les bascules bistables de type JK (1B, 2B) de l'autre canal (B) de transmission des signaux sont commandées par les flancs négatifs du même train d'impulsions de cadence.

FIG 1

FIG 2

SA

SB

B

A

Z

FIG 3

0 089 511